(19) Europäisches Patentamt / European Patent Office / Office européen des brevets

(11) **EP 3 299 991 B1**

(12) **FASCICULE DE BREVET EUROPEEN**

(45) Date de publication et mention
de la délivrance du brevet:
**25.03.2020 Bulletin 2020/13**

(51) Int Cl.:
**G06G 7/186** (2006.01)    **H03K 5/24** (2006.01)
**G06G 7/14** (2006.01)

(21) Numéro de dépôt: **17192979.7**

(22) Date de dépôt: **25.09.2017**

(54) **CIRCUIT SOMMATEUR**

**SUMMIERSCHALTUNG**

**SUMMING CIRCUIT**

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **26.09.2016 FR 1659032**

(43) Date de publication de la demande:
**28.03.2018 Bulletin 2018/13**

(73) Titulaire: **Commissariat à l'Energie Atomique et
aux Energies
Alternatives
75015 Paris (FR)**

(72) Inventeurs:
• **ROSTAING, Jean-Pierre
38260 La Côte Saint-Andre (FR)**
• **DUPONT, Bertrand
38360 Sassenage (FR)**
• **MONNIER, Nicolas
38000 Grenoble (FR)**
• **NICOLAS, Jean-Alain
38120 Saint Egreve (FR)**

(74) Mandataire: **Cabinet Beaumont
4, Place Robert Schuman
B.P. 1529
38025 Grenoble Cedex 1 (FR)**

(56) Documents cités:
GB-A- 2 220 771        US-A- 4 086 656
US-A1- 2007 252 575

• SUZANA DOMINGUES ET AL: "A CMOS THz
staring imager with in-pixel electronics", PH.D.
RESEARCH IN MICROELECTRONICS AND
ELECTRONICS (PRIME), 2011 7TH
CONFERENCE ON, IEEE, 3 juillet 2011
(2011-07-03), pages 81-84, XP031907780, DOI:
10.1109/PRIME.2011.5966222 ISBN:
978-1-4244-9138-4

**EP 3 299 991 B1**

**Description**

Domaine

La présente demande concerne un circuit sommateur recevant des signaux d'entrée successifs et fournissant un signal de sortie représentatif de la somme des signaux d'entrée successifs.

Exposé de l'art antérieur

Pour certaines applications, il est souhaitable de disposer d'un circuit sommateur à grande dynamique.

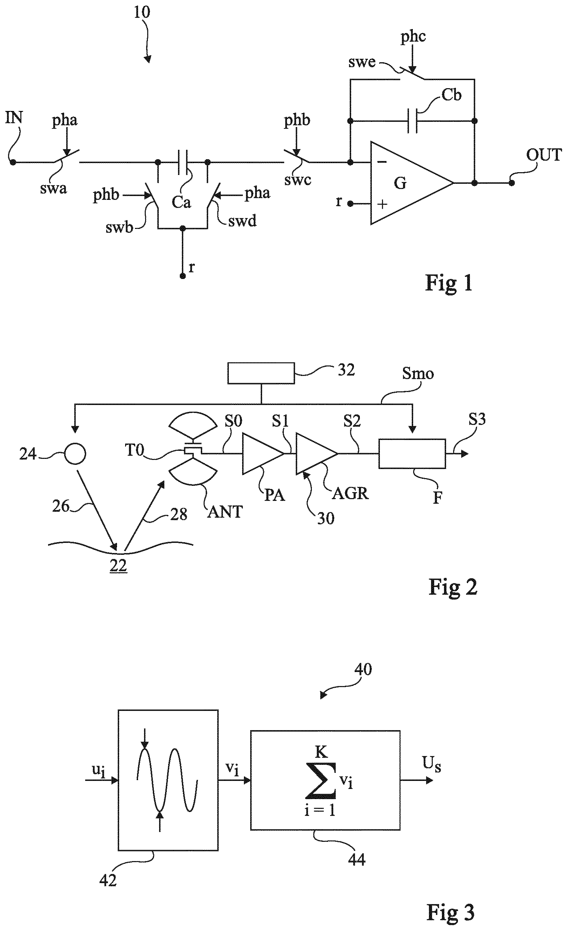

La figure 1 représente un exemple connu de circuit sommateur 10 également appelé intégrateur, sommateur ou circuit intégrateur. Le circuit sommateur 10 comprend un noeud d'entrée IN recevant un signal analogique à sommer. Le circuit 10 comprend deux condensateurs Ca et Cb et un amplificateur opérationnel G. Une armature du condensateur Ca est reliée au noeud IN par un interrupteur swa commandé par un signal binaire pha et est reliée à un noeud r par un interrupteur swb commandé par un signal binaire phb. Le noeud r est maintenu à un potentiel de référence constant. L'autre armature du condensateur Ca est reliée à l'entrée inverseuse (-) de l'amplificateur opérationnel G par un interrupteur swc commandé par le signal phb et est reliée au noeud r par un interrupteur swd commandé par le signal pha. L'entrée non inverseuse (+) de l'amplificateur opérationnel G est reliée au noeud r. Une armature du condensateur Cb est reliée à l'entrée inverseuse (-) de l'amplificateur opérationnel G et l'autre armature du condensateur Cb est reliée à la sortie OUT de l'amplificateur opérationnel G. Un interrupteur swe commandé par un signal binaire phc est prévu aux bornes du condensateur Cb.

Le fonctionnement du circuit sommateur 10 comprend une succession de cycles. Avant le premier cycle, l'interrupteur swe est fermé pour remettre à zéro la tension aux bornes du condensateur Cb. Chaque cycle de fonctionnement du circuit sommateur 10 comprend les étapes successives suivantes :

-    les interrupteurs swa et swd sont fermés et les interrupteurs swb et swc sont ouverts. Ceci entraîne la charge du condensateur Ca avec la tension V(in)-V(r), notée V(in,r). La charge électrique Q stockée par le condensateur Ca est donc égale au produit Ca.V(in,r) ;
-    les interrupteurs swa et swd sont ouverts et les interrupteurs swb et swc sont fermés. Le condensateur Ca est monté entre le noeud r et l'entrée inverseuse (-) de l'amplificateur opérationnel G qui se trouve au potentiel V(r) égal à V(+). Le condensateur Ca se décharge alors dans le condensateur Cb qui prend ainsi la charge Q. La tension V(out,r) aux bornes du condensateur Cb augmente donc de la valeur Q/Cb c'est-à-dire de la valeur V(in,r).Ca/Cb.

La tension V(out,r) suit donc la relation (1) suivante :

$$V(out,r) = \frac{1}{Cb} \sum_{i=1}^{K} Q_i = \frac{Ca}{Cb} \sum_{i=1}^{K} V_i (in,r) \qquad (1)$$

Pour certaines applications, la charge totale $Q_{PE}$ qui est égale à la somme des charges élémentaires $Q_i$ peut être supérieure à quelques nanocoulombs, c'est-à-dire plusieurs milliers de pF.V. Il faut donc que le circuit sommateur 10 ait une dynamique $Q_{PE}/Qi$ supérieure à $10^6$, c'est-à-dire supérieure à 120 dB.

En pratique, la dynamique du circuit sommateur 10 est limitée par :

-    le rapport de capacité Ca/Cb ; et
-    l'excursion de tension E du circuit sommateur 10 qui est inférieure à la tension d'alimentation Vdd du circuit sommateur 10.

A titre d'exemple, lorsque le circuit sommateur 10 est réalisé par des procédés classiques de fabrication de circuits intégrés, par exemple en mettant en oeuvre une technologie pour laquelle la longueur de grille des transistors à effet de champ à grille isolée ou MOSFET (sigle anglais pour Metal Oxide Semiconductor Field Effect Transistor) est de 130 nm, la capacité minimale qui peut être obtenue peut être de l'ordre de 30 fF, la capacité maximale qui peut être obtenue peut être de l'ordre de 3pF et la tension d'alimentation Vdd peut être de l'ordre de 1,2 V. Le rapport Ca/Cb est alors inférieur à 100 et l'excursion de tension E est également inférieure à 1 V. Il est donc impossible d'atteindre une charge de plusieurs milliers de pF.V avec un circuit sommateur ayant la structure représentée sur la figure 1. Suzana Domingues et al: "A CMOS THz staring imager with in-pixel electronics", 2011-07-03, DOI: 10.1109/PRIME.2011.5966222, ISBN: 978-1-4244-9138-4, pages 81-84, dévoile un circuit sommateur comprenant un condensateur, un circuit de commutation, un intégrateur, un comparateur et un compteur.

Résumé

Un objet d'un mode de réalisation est de prévoir un circuit sommateur palliant tout ou partie des inconvénients des circuits sommateurs existants.

Un autre objet d'un mode de réalisation est que le circuit sommateur ait une dynamique supérieure à $10^6$.

Un autre objet d'un mode de réalisation est que le circuit sommateur permette la détermination d'une charge totale, correspondant à la somme de charges élémentaires, qui soit supérieure à plusieurs milliers de pF.V.

Un autre objet d'un mode de réalisation est que le circuit sommateur puisse être réalisé par des procédés classiques de fabrication de circuits intégrés.

Ainsi, un mode de réalisation prévoit un circuit sommateur selon chacune des revendications 1-7 en annexe.

Un mode de réalisation prévoit également un circuit de traitement et détermination de somme selon chacune des revendications 8 et 9 en annexe.

Un mode de réalisation prévoit également un système de détection d'un rayonnement électromagnétique selon chacune des revendications 10-12 en annexe.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1, décrite précédemment, représente un exemple de circuit intégrateur ;

la figure 2 est un schéma représentant un système de détection d'une image térahertz ;

la figure 3 représente, de façon partielle et schématique, un mode de réalisation d'un circuit de traitement et de détermination de somme ;

la figure 4 représente, de façon partielle et schématique, un mode de réalisation d'un circuit extracteur d'amplitude du circuit de traitement et de détermination de somme de la figure 3 ;

la figure 5 représente des courbes d'évolution de signaux au cours du fonctionnement du circuit extracteur d'amplitude de la figure 4 ;

la figure 6 représente, de façon partielle et schématique, un mode de réalisation d'un circuit sommateur du circuit de traitement et de détermination de somme de la figure 3 ;

la figure 7 est une courbe d'évolution d'un signal fourni par un circuit à hystérésis du circuit sommateur de la figure 6 en fonction du signal reçu par le circuit à hystérésis ;

la figure 8 représente un mode de réalisation d'un graphe de fonctionnement du circuit sommateur de la figure 6 ;

la figure 9 représente des courbes d'évolution de signaux au cours du fonctionnement du circuit sommateur de la figure 6 ;

la figure 10 représente des courbes d'évolution de signaux illustrant le fonctionnement du circuit de traitement et de détermination de somme de la figure 3 ; et

la figure 11 représente une courbe d'évolution de la charge électrique déterminée à partir des signaux fournis par le circuit de traitement et détermination de somme de la figure 3 pour d'autres paramètres de fonctionnement.

Description détaillée

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés. En particulier, les sources d'un rayonnement térahertz sont des systèmes bien connus de l'homme du métier et ne seront pas décrits en détail par la suite. Sauf précision contraire, l'expression "de l'ordre de" signifie à 10 % près, de préférence à 5 % près.

En outre, on appelle "signal binaire" un signal qui alterne entre un premier état constant, par exemple un état bas, noté "0", et un deuxième état constant, par exemple un état haut, noté "1". Les états haut et bas de signaux binaires différents d'un même circuit électronique peuvent être différents. En pratique, les signaux binaires peuvent correspondre à des tensions ou à des courants qui peuvent ne pas être parfaitement constants à l'état haut ou bas.

En outre, dans la présente description, on utilise le terme "connecté" pour désigner une liaison électrique directe, sans composant électronique intermédiaire, par exemple au moyen d'une piste conductrice, et le terme "couplé" ou le terme "relié", pour désigner soit une liaison électrique directe (signifiant alors "connecté") soit une liaison via un ou plusieurs composants intermédiaires (résistance, condensateur, etc.).

En outre, dans la présente description, on utilise la même référence pour désigner un composant électronique sur les figures et pour désigner une propriété, la résistance ou la capacité, de ce composant électronique. De plus, on note le potentiel à un noeud N1 par V(N1) et on note la tension entre deux noeuds N2 et N3 par V(N2,N3) ou par V(N2)-V(N3) .

En outre, dans la présente description, lorsqu'il est décrit qu'un interrupteur est commandé par un signal binaire, on considère à titre d'exemple que l'interrupteur est fermé lorsque le signal binaire est à "1" et que l'interrupteur est ouvert lorsque le signal binaire est à "0". L'interrupteur peut correspondre à un transistor MOS dont la grille est commandée par le signal binaire.

Les inventeurs ont mis en évidence que l'utilisation d'un circuit sommateur à grande dynamique pouvait permettre d'augmenter le rapport signal sur bruit d'un imageur térahertz.

Un imageur térahertz ou capteur d'image térahertz comprend une matrice de capteurs adaptés chacun à détecter un rayonnement térahertz. Chaque capteur, également appelé pixel, définit la résolution spatiale de l'imageur. Le domaine des fréquences térahertz s'étend de 100 GHz à 30 THz environ, ce qui correspond à des longueurs d'ondes comprises entre 0,01 mm et 3 mm. Les rayonnements térahertz ont un fort pouvoir pénétrant. Ils permettent potentiellement de voir à travers de nombreux matériaux non conducteurs tels que la peau, les vêtements, le papier, le bois, le carton, les plastiques, etc. Les ondes térahertz peut être utilisées en imagerie de la même façon que les rayons infrarouge, en radioastronomie, en radiométrie planétaire et en sondage météo.

La figure 2 représente, de façon partielle et schématique, un système 20 de détermination d'une image térahertz d'une scène 22. Le système 20 comprend une source 24 d'un rayonnement térahertz 26 qui se réfléchit sur la scène 22. Le système 20 comprend, en outre, une matrice de détecteurs du rayonnement térahertz 28 réfléchi par la scène 22, un seul détecteur 30 étant représenté en figure 2. De façon générale, le signal reçu par le détecteur 30 est de faible amplitude et nécessite un traitement pour l'extraire du bruit.

Il existe de nombreux types différents de procédés de détection d'un rayonnement térahertz. Les procédés de détection directe fournissent un signal qui est représentatif de l'intensité du rayonnement térahertz. Les procédés de détection directe peuvent mettre en oeuvre des détecteurs pneumatiques, notamment des cellules de Golay, des détecteurs pyroélectriques, des diodes Schottky, des bolomètres, des détecteurs térahertz à base de transistors à effet de champ. Les procédés de détection indirecte ou cohérente comprennent la modulation du rayonnement térahertz avec un signal oscillant à une fréquence de référence et le filtrage du signal reçu à la fréquence de référence.

En figure 2, on a représenté un générateur 32 d'un signal Smo oscillant à une fréquence basse fmo, qui varie par exemple de 1 kHz à 10 MHz, et d'amplitude crête à crête constante, le signal Smo étant transmis à la source 22 et au détecteur 30. Le rayonnement térahertz 26 est modulé en amplitude par le signal Smo. Chaque détecteur 30 reçoit l'onde térahertz réfléchie 28 modulée en amplitude à la fréquence fmo. A titre d'exemple, pour chaque détecteur 30, l'onde térahertz est captée par une antenne ANT adaptée et couplée à un transistor MOS T0 qui fournit un signal S0. Chaque détecteur 30 comprend un préamplificateur faible bruit PA recevant le signal S0 et fournissant un signal S1 et dont le rôle est d'amplifier le signal S0 en y ajoutant le minimum de bruit. Chaque détecteur 30 comprend, en outre, un amplificateur à gain réglable AGR recevant le signal S1 et fournissant un signal S2 et qui permet d'adapter le niveau du signal S2 en fonction de consignes extérieures. On dispose alors d'un signal S2 optimal rapporté à un bruit dont la densité de puissance est incompressible. Chaque détecteur 30 comprend, en outre, un filtre F très sélectif centré sur la fréquence de modulation fmo recevant le signal S2 et fournissant un signal S3. A titre d'exemple, le filtre F correspond au filtre synchrone décrit dans la demande de brevet WO 2015040316. Le signal S3 est un signal oscillant à la fréquence fmo qui a une amplitude crête à crête qui dépend de la distance entre le détecteur 30 et la scène 22 et du pouvoir réfléchissant de la scène 22. L'amplitude du signal S3 peut être très faible, par exemple de l'ordre de 1 μV, et proche du bruit thermique. Une image, appelée image térahertz, peut être déterminée à partir des signaux S3 fournis par la matrice de détecteurs 30. L'imageur peut fournir des images à une fréquence Ftram. A titre d'exemple, l'imageur peut fournir 10 images par seconde, ce qui correspond à une durée de trame Ttram de 100 ms.

Bien que le filtre F permette d'augmenter le rapport signal sur bruit (SNR) du signal S3 par rapport au signal S2, il serait souhaitable d'augmenter davantage le rapport signal sur bruit de l'imageur térahertz.

Les inventeurs ont mis en évidence que pour améliorer le rapport signal sur bruit de l'imageur térahertz, on peut utiliser le fait que l'amplitude crête à crête du signal S3 pendant une durée de trame Ttram est sensiblement constante. Pendant chaque durée de trame Ttram, il y a Ttram*fmo oscillations du signal S3, ce qui correspond à $10^4$ périodes du signal S3 lorsque la durée Ttram est égale à 100 ms et la fréquence fmo est égale à 100 kHz. On peut donc disposer de K échantillons, K étant égal à égal à $10^4$ dans le présent exemple, d'un signal stationnaire (le signal Sm0 utilisé pour la modulation est d'amplitude crête à crête constante) entaché d'un bruit lui-même stationnaire (dont la moyenne est invariable dans le temps). En effectuant la somme des K échantillons, on peut obtenir pour le signal de somme une augmentation du rapport signal sur bruit égale à la racine carrée de K, c'est-à-dire 100 dans le présent exemple.

Toutefois, pour l'imageur térahertz, déterminer le signal de somme revient à déterminer la somme de K échantillons de charge élémentaire $Q_i$ où $Q_i$ peut varier de 5 fC à 500 fC. La charge totale $Q_{PE}$ peut atteindre 5 nC, c'est-à-dire 5000 pF.V. Il faut donc que le circuit intégrateur ait une dynamique $Q_{PE}/Qi$ égale à $10^6$, c'est-à-dire 120 dB. Un circuit intégrateur ayant la structure représentée en figure 2 ne peut donc pas être utilisé à cette fin.

La figure 3 représente un mode de réalisation d'un circuit de traitement et détermination de somme 40 qui est adapté à être utilisé avec le détecteur térahertz 30 décrit précédemment en relation avec la figure 2. Le circuit 40 comprend :

- un circuit extracteur d'amplitude 42 recevant un signal oscillant $u_i$ et fournissant un signal $v_i$ égal à l'amplitude crête à crête du signal bruité $u_i$ sur une oscillation du signal $u_i$ ; et
- un circuit sommateur 44 qui reçoit l'échantillon $v_i$, l'additionne aux précédents et produit un signal de somme $U_S$ représentatif de la somme de K échantillons reçus pendant une durée d'intégration Tint.

Selon un exemple de réalisation, la durée d'intégration Tint est égale à la durée de trame Ttram.

Lorsque le circuit de traitement et détermination de somme 40 est utilisé avec le système 20 de détermination d'une image térahertz décrit précédemment en relation avec la figure 2, le signal $u_i$ correspond au signal S3 fourni par le détecteur 30.

Selon un mode de réalisation, au lieu de déterminer directement un signal analogique dont l'amplitude est proportionnelle à la somme à déterminer, le circuit sommateur 44 incrémente un compteur à chaque fois que la somme à déterminer augmente d'une quantité élémentaire déterminée. La somme finale peut alors être obtenue par le produit du compteur et de la quantité élémentaire. Dans ce but, le circuit sommateur 44 fait alternativement augmenter et diminuer un signal analogique chaque fois que la somme des échantillons de charges en entrée dépasse la quantité élémentaire. Le compteur est alors incrémenté chaque fois que le signal analogique change de sens d'évolution. Tout se passe comme si le signal de somme totale était replié en un signal "replié" dont l'amplitude crête à crête est bornée. L'opération de repliement peut être réalisée par un comparateur à hystérésis. Par repliement de la somme des échantillons de charges, le circuit sommateur permet d'atteindre la dynamique de 5000 V.pF.

Le circuit extracteur d'amplitude 42 fournit les échantillons dont on souhaite déterminer la somme. Dans le présent mode de réalisation, les échantillons correspondent à l'amplitude crête à crête d'un signal oscillant. Toutefois, en fonction de la nature du signal reçu par le circuit de traitement et détermination de somme 40, le circuit extracteur d'amplitude 42 peut être remplacé par un autre type de circuit de prétraitement. En particulier, lorsque le signal reçu par le circuit de traitement et détermination de somme 40 correspond directement à une succession de valeurs constantes, le circuit de traitement et détermination de somme 40 peut ne comprendre que le circuit sommateur 44.

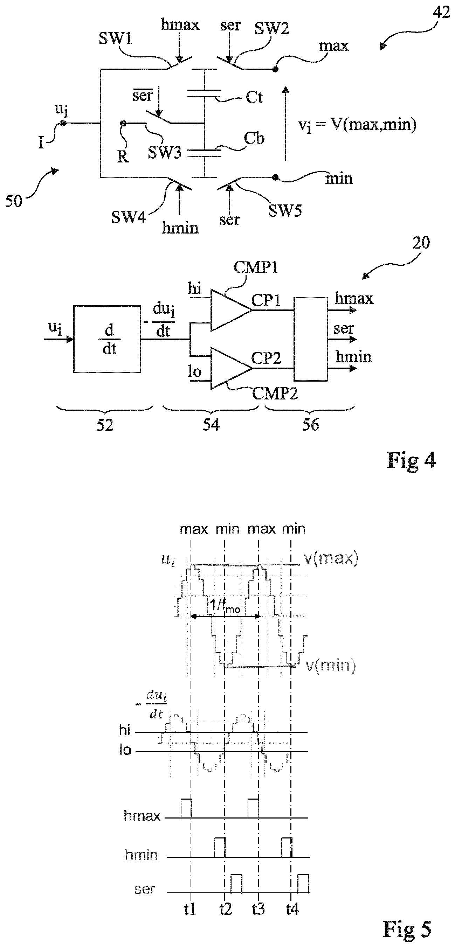

La figure 4 représente, de façon partielle et schématique, un mode de réalisation du circuit extracteur d'amplitude 42.

Le circuit extracteur d'amplitude 42 comprend quatre blocs 50, 52, 54 et 56. Le circuit extracteur d'amplitude 42 est alimenté sous une tension Vdda, par exemple égale à 1,2 V.

Le bloc 50 comprend des condensateurs Ct et Cb. Une armature du condensateur Ct est reliée à un noeud I par l'intermédiaire d'un interrupteur SW1 commandé par un signal binaire **hmax** et reliée à un noeud max par l'intermédiaire d'un interrupteur SW2 commandé par un signal **ser**. L'autre armature du condensateur Ct est reliée à un noeud Vref par l'intermédiaire d'un interrupteur SW3 commandé par le signal binaire $\overline{\text{ser}}$ (qui est le signal complémentaire du signal binaire **ser).** Une armature du condensateur Cb est reliée au noeud I par l'intermédiaire d'un interrupteur SW4 commandé par un signal binaire **hmin** et reliée à un noeud min par l'intermédiaire d'un interrupteur SW5 commandé par le signal **ser.** L'autre armature du condensateur Cb est reliée au noeud R par l'intermédiaire de l'interrupteur SW3. Le noeud I reçoit le signal $u_i$. Le noeud R est maintenu à un potentiel constant. Le signal $v_i$ correspond à la tension V(max,min) entre les noeuds max et min.

Le bloc 52 reçoit le signal $u_i$ et fournit un signal $-du_i/dt$ égal à l'inverse de la dérivée temporelle du signal $u_i$. Le bloc 52 comprend par exemple un circuit RC et un amplificateur opérationnel.

Le bloc 54 comprend un premier comparateur CMP1 recevant à une première entrée un seuil de comparaison haut hi et recevant à une deuxième entrée le signal $-du_i/dt$ et fournissant un signal binaire CP1 à un premier état, par exemple "1", lorsque le signal $-du_i/dt$ est inférieur au seuil de comparaison haut hi et à un deuxième état, par exemple "0", lorsque le signal $-du_i/dt$ est supérieur au seuil de comparaison haut hi. Le bloc 54 comprend un deuxième comparateur CMP2 recevant à une première entrée le signal $-du_i/dt$ et recevant à une deuxième entrée un seuil de comparaison bas lo et fournissant un signal binaire CP2 à un premier état, par exemple "1", lorsque le signal $-du_i/dt$ est supérieur au seuil de comparaison bas lo et à un deuxième état, par exemple "0", lorsque le signal -dui/dt est inférieur au seuil de comparaison bas lo.

Le bloc 56 est un circuit logique recevant les signaux binaires CP1 et CP2 et fournissant les signaux de commande hmax, **hmin** et **ser.**

Le fonctionnement du circuit extracteur d'amplitude 42 comprend une succession de cycles pour chaque période Tmo égale à 1/fmo.

La figure 5 représente des courbes d'évolution des signaux $u_i$, $-du_i/dt$, **hmax, hmin** et **ser** au cours de deux cycles de fonctionnement du circuit extracteur d'amplitude 42. On appelle t1, t2, t3 et t4 des instants successifs.

Le circuit logique 56 est défini de façon que seul l'un des signaux **hmax, hmin** et **ser** est à l'état "1" à la fois.

Le circuit logique 56 met le signal **hmax** à "1" pendant une durée déterminée peu après que le signal -dui/dt dépasse le seuil hi de sorte que le front descendant du signal **hmax** se produise lorsque le signal $u_i$ passe par un maximum, ce qui correspond aux instants t1 et t3 en figure 5. Le circuit logique 56 met le signal **hmin** à "1" pendant une durée déterminée peu après que le signal -dui/dt diminue sous le seuil lo de sorte que le front descendant du signal **hmin** se produise lorsque le signal $u_i$ passe par un minimum, ce qui correspond aux instants t2 et t4 en figure 5. Le circuit logique 56 met le signal **ser** à "1" pendant une durée déterminée entre le dernier front descendant du signal **hmin** et le prochain front montant du signal **hmax.**

Lorsque le signal **hmax** est égal à "1" et le signal ser est à "0", les interrupteurs SW1 et SW3 sont fermés et le condensateur Ct est chargé avec la tension V($u_i$,ref). Lorsque le signal **hmax** passe de "1" à "0", la valeur maximale V(max) du signal $u_i$ est échantillonnée sur le condensateur Ct. Lorsque le signal **hmin** est égal à "1" et le signal **ser** est à "0", les interrupteurs SW4 et SW3 sont fermés et le condensateur Cp est chargé avec la tension V(ref,$u_i$). Lorsque le signal **hmin** passe de "1" à "0", la valeur maximale V(min) du signal $u_i$ est échantillonnée sur le condensateur Cp. Lorsque le signal **ser** est à "1", les condensateurs Ct et Cp sont mis en série et la tension crête à crête V(max,min) est appliquée entre les noeuds max et min et fournie au circuit sommateur 44.

Le circuit extracteur d'amplitude 42 réalise de façon avantageuse un double échantillonnage corrélé sur le signal $u_i$, filtrant ainsi les basses fréquences indésirables inférieures à la moitié de la fréquence fmo.

En outre, le bruit d'échantillonnage kT/C du circuit extracteur d'amplitude 42 est négligeable sur la durée Ttram. En effet, pour une capacité d'échantillonnage de 1pF, le bruit d'échantillonnage kT/C est égal à 64 $\mu$V multiplié par la racine carrée de 2 puisqu'il y a deux échantillons par cycle. Il en résulte un bruit kT/C de 90 $\mu$V réduit par les $10^4$ échantillons à 0,9 $\mu$V à la fin de la trame.

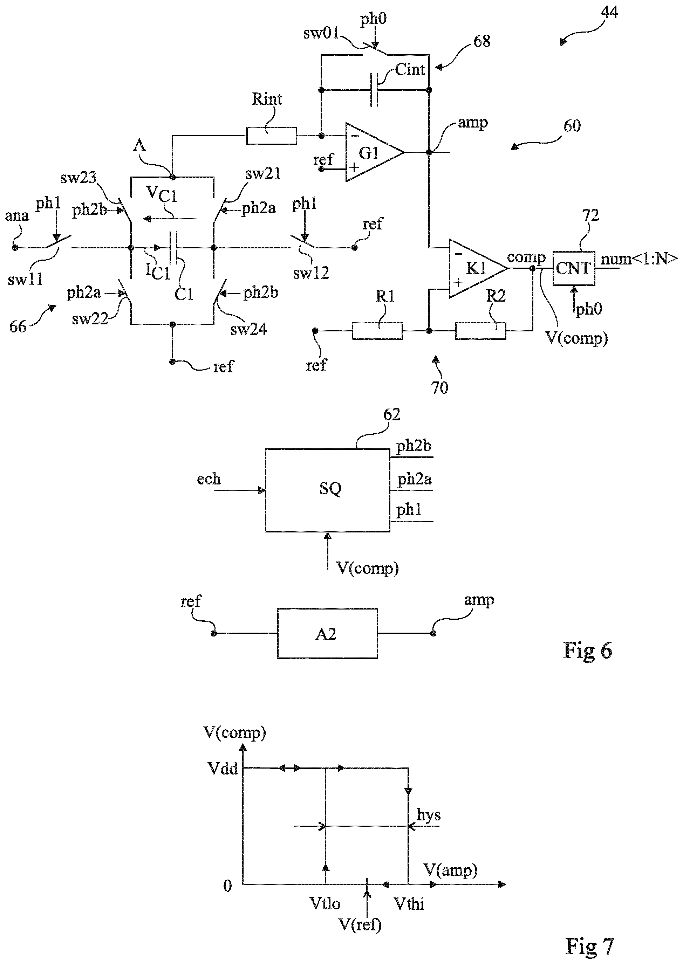

La figure 6 représente de façon partielle et schématique un mode de réalisation du circuit sommateur 44.

Le circuit sommateur 44 comprend deux blocs 60 et 62. Le circuit sommateur 44 est alimenté par la tension d'alimentation Vdda, par exemple égale à 1,2 V.

Le bloc 60 comprend successivement un commutateur de capacité 66, un intégrateur 68, un comparateur à hystérésis 70 et un compteur 72.

Le commutateur de capacité 66 comprend un noeud d'entrée ana recevant plusieurs signaux $v_i$ successifs dont la somme est à déterminer. Le bloc 60 comprend un condensateur C1 dont une armature est reliée au noeud ana par un interrupteur sw11 commandé par un signal binaire ph1. Cette armature est en outre reliée à un noeud ref par un interrupteur sw22 commandé par un signal binaire ph2a et est reliée à un noeud A par un interrupteur sw23 commandé par un signal binaire ph2b. L'armature du condensateur C1 est reliée au noeud ref par un interrupteur sw12 commandé par le signal ph1. Cette armature est également reliée au noeud A par un interrupteur sw21 commandé par le signal ph2a et au noeud ref par un interrupteur sw24 commandé par le signal ph2b. La tension aux bornes du condensateur C1 est appelée $V_{C1}$ et le courant traversant le condensateur C1 est appelé $I_{C1}$.

L'intégrateur 68 comprend une résistance Rint dont une borne est reliée au noeud A et dont l'autre borne est reliée à l'entrée inverseuse (-) d'un amplificateur opérationnel G1. L'entrée non inverseuse (+) de l'amplificateur opérationnel G1 est reliée au noeud ref. L'intégrateur 68 comprend, en outre, un condensateur Cint dont une armature est reliée à l'entrée inverseuse (-) de l'amplificateur opérationnel G1, l'autre armature du condensateur Cint étant reliée à la sortie amp de l'amplificateur opérationnel G1. Un interrupteur sw01 commandé par un signal binaire ph0 est prévu aux bornes du condensateur Cint.

L'intégrateur 68 peut en outre comprendre un circuit d'annulation d'offset AZ ou auto-zero connecté aux noeuds ref et amp, dont le rôle est d'annuler l'offset de l'amplificateur G1. Le circuit d'annulation d'offset AZ peut ne pas être présent.

Le comparateur à hystérésis 70 comprend un comparateur K1 comprenant une entrée négative (-) reliée à la sortie amp de l'amplificateur G1 et comprenant une entrée positive (+) reliée à un noeud th. Le bloc 60 comprend une résistance R1 dont une borne est reliée au noeud ref et dont l'autre borne est reliée au noeud th. Le bloc 60 comprend une résistance R2 dont une borne est reliée au noeud th et dont l'autre borne est reliée à la sortie comp du comparateur K1. Le comparateur K1 fournit un signal binaire V(comp) qui peut prendre deux états notés Vdd et 0 par la suite.

Le compteur 72 comprend un compteur binaire CNT recevant le signal V(comp), recevant le signal ph0 et fournissant un signal numérique num comprenant N bits, où N est un entier qui peut varier de 1 à 20. Selon un exemple de réalisation, N est choisi selon la dynamique DYN requise exprimée en dB selon la relation (2) suivante :

$$N=DYN/(20*log2) \tag{2}$$

où log est le logarithme décimal.

A titre de variante, le compteur binaire CNT peut être remplacé par un compteur décimal ou tout autre type de compteur. Le compteur CNT incrémente le signal num d'une unité sur chaque transition montante et chaque transition descendante du signal V(comp). Le signal binaire num peut être transmis à un circuit de traitement, qui peut être externe à l'imageur térahertz. A titre d'exemple, la détermination d'une image térahertz peut être réalisée à partir des signaux binaires num reçus pour tous les détecteurs.

Le bloc 62 comprend un séquenceur recevant un signal ech et le signal V(comp) et fournissant les signaux ph1, ph2a et ph2b. Le séquenceur 62 peut fonctionner selon un automate fini.

En fonctionnement, la tension V(max)-V(min) fournie par le circuit extracteur d'amplitude 42 est appliquée entre les noeuds ana et ref du circuit sommateur 44. Le noeud min du circuit extracteur d'amplitude 42 est donc connecté au noeud ref, dont le potentiel est fixé par une source de tension, par exemple à Vdda/2. En fonctionnement, le signal ech correspond au signal ser fourni par le circuit extracteur d'amplitude 42.

Selon un exemple de réalisation, le noeud max du circuit extracteur d'amplitude 42 est relié directement à l'entrée ana du circuit sommateur 44. Il y a alors partage de charges électriques entre le condensateur équivalent Cex vue en sortie du circuit extracteur d'amplitude 42 et le condensateur C1 du circuit sommateur 44, la capacité Cex du condensateur équivalent étant donnée par la relation (3) suivante :

$$\text{Cex=(Ct.Cb)/(Ct+Cb)} \qquad\qquad (3)$$

Dans le cas où Cb est égal à Ct, la capacité Cex est égale à Ct/2. Il peut être avantageux de choisir Cex supérieur à C1 d'au moins un facteur 10 pour ne pas trop atténuer la charge électrique transférée au condensateur C1.

Selon un autre mode de réalisation, le noeud max du circuit extracteur d'amplitude 42 est relié à l'entrée ana du circuit sommateur 44 par l'intermédiaire d'un suiveur de tension à forte impédance d'entrée et faible impédance de sortie. Il n'y a alors pas atténuation de la charge transférée au condensateur C1. Toutefois, le suiveur consomme un peu de puissance et de surface.

La figure 7 est une courbe d'évolution du signal V(comp) fourni par le comparateur à hystérésis 70 en fonction du potentiel V(amp) et illustre le fonctionnement du comparateur à hystérésis 70. Le potentiel V(amp) est référencé à la masse prise égale à 0 V. Lorsque le potentiel V(amp) est à 0 V, le potentiel V(comp) est à Vdd. Le potentiel V(comp) reste égal à Vdd lorsque V(amp) augmente depuis 0 V jusqu'à ce que V(amp) dépasse un seuil $V_{thi}$. Le potentiel V(comp) bascule alors à 0. Lorsque le potentiel V(amp) diminue depuis une valeur supérieure à $V_{thi}$, le potentiel V(comp) reste à 0 jusqu'à ce que V(amp) diminue en dessous d'un seuil $V_{tlo}$. Le potentiel V(comp) bascule alors à Vdd. Les seuils $V_{thi}$ et $V_{tlo}$ sont données par les relations (4) suivantes :

$$\begin{aligned} V_{thi} &= V(ref) + hys/2 \qquad\qquad (4)\\ V_{tlo} &= V(ref) - hys/2 \\ hys &= Vdd *R1/(R1+R2) \end{aligned}$$

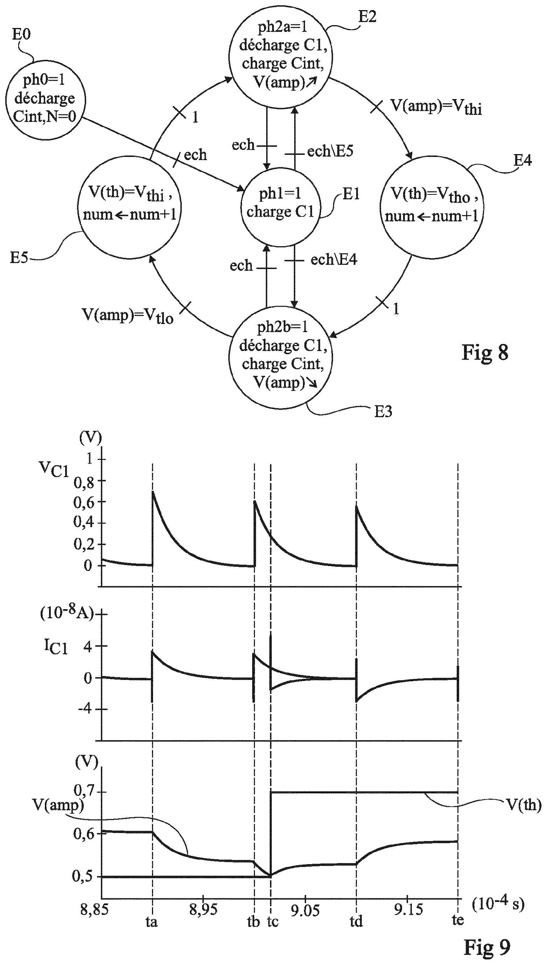

La figure 8 représente un mode de réalisation du graphe de fonctionnement du circuit sommateur 44 comprenant des états E0, E1, E2, E3, E4 et E5. La succession d'états est répétée pour chaque trame.

Le circuit sommateur 44 débute à l'état E0 dans lequel les signaux ph1, ph2a et ph2b sont "0". Le signal ph0 qui peut être fourni par un circuit extérieur à l'imageur térahertz, est à "1" ce qui remet à zéro la charge stockée dans le condensateur d'intégration Cint. Le séquenceur 62 passe par l'état E0 une seule fois au début de la trame. L'état E0 dure typiquement quelques nanosecondes, cette durée pouvant être fixée par une bascule monostable.

Le circuit sommateur 44 passe de l'état E0 à l'état E1 lorsque le signal ech passe de l'état "0" à l'état "1". A l'état E1, le signal ph1 est à "1", les signaux ph2a et ph2b étant à "0". Le condensateur C1 est chargé avec la tension V(ana,ref). La durée de charge peut durer de 10 ns à 50 ns.

Le circuit sommateur 44 passe de l'état E1 à l'état E2 lorsque le signal ech passe de l'état "1" à l'état "0" alors que le signal V(th) est égal à $V_{thi}$. A l'état E2, le signal ph2a est à "1", les signaux ph1 et ph2b étant à "0". Il y a décharge du condensateur C1 et charge du condensateur Cint. Le potentiel V(amp) augmente. Le circuit sommateur 44 repasse de l'état E2 à l'état E1 lorsque le signal ech passe de l'état "0" à l'état "1".

Le circuit sommateur 44 passe de l'état E1 à l'état E3 lorsque le signal ech passe de l'état "1" à l'état "0" alors que le signal V(th) est à $V_{tlo}$. A l'état E3, le signal ph2b est à "1", les signaux ph1 et ph2a étant à "0". Il y a décharge du condensateur C1 et décharge du condensateur Cint. Le potentiel V(amp) diminue. Le circuit sommateur 44 repasse de l'état E3 à l'état E1 lorsque le signal ech passe de l'état "0" à l'état "1".

Le circuit sommateur 44 passe de l'état E2 à l'état E4 lorsque le signal V(amp) qui augmente atteint $V_{thi}$. A l'état E4, le signal V(comp) passe de Vdd à 0. De plus, le signal V(th) passe de $V_{thi}$ à $V_{tlo}$ et le signal numérique num est incrémenté de "1".

Le circuit sommateur 44 passe de l'état E3 à un état E5 lorsque le signal V(amp) qui diminue atteint $V_{tlo}$. A l'état E5, le signal V(comp) passe de 0 à Vdd. De plus, le signal V(th) passe de $V_{tlo}$ à $V_{thi}$ et le signal numérique num est incrémenté de "1". Le circuit sommateur 44 passe alors de l'état E5 à l'état E2.

Selon un autre mode de réalisation, le circuit sommateur 44 peut passer directement de l'état E2 à l'état E3 lorsque le signal V(amp) qui augmente atteint $V_{thi}$ et que la décharge du condensateur C1 n'est pas complète.

Selon un autre mode de réalisation, le circuit sommateur 44 peut passer directement de l'état E3 à l'état E2 lorsque le signal V(amp) qui diminue atteint $V_{tlo}$ et que la décharge du condensateur C1 n'est pas complète.

La résistance Rint a pour but de limiter le courant de décharge du condensateur C1 et est choisie telle que le produit Rint.C1 soit inférieur à la période Tmo d'au moins un facteur dix pour assurer la décharge complète du condensateur C1 entre deux échantillons.

La figure 9 représente des courbes d'évolution en fonction du temps de la tension $V_{C1}$, du courant $I_{C1}$, du potentiel V(amp) et du potentiel V(th). Les instants ta, tb, tc, td et te sont des instants successifs. A $8,85 \cdot 10^{-4}$ s le potentiel V(th) est au seuil bas $V_{tlo}$ égal à 0,5 V dans cet exemple.

Aux instants ta et tb, le signal ech passe à "1" ce qui correspond à l'application d'un nouvelle échantillon $v_i$ en entrée du circuit sommateur 44. Le circuit sommateur 44 passe alors l'état E1 et ce qui correspond à la charge du condensateur C1. On observe ainsi une augmentation en valeur absolue de la tension $V_{C1}$ à chaque instant ta et tb. Le front descendant du signal ech commande le passage du sommateur 44 à l'état E3 puisque le signal V(th) est à $V_{tlo}$. On observe donc la décharge du condensateur C1 avec une diminution en valeur absolue de la tension $V_{C1}$ entre les instants ta et tb, et entre les instants tb et tc.

A l'instant tc, le signal V(comp) bascule de l'état bas à l'état haut lorsque le potentiel V(amp) qui diminuait jusqu'alors atteint le seuil bas $V_{tlo}$. Ceci correspond au passage de l'état E3 à l'état E5 dans lequel le compteur 72 incrémente le signal binaire num. En outre, le potentiel V(th) bascule alors de $V_{tlo}$ à $V_{thi}$. Le circuit sommateur 44 passe alors de l'état E5 à l'état E2 dans lequel la connexion du condensateur C1 est inversée par rapport à celle de l'état E3. Le signe du courant $I_{C1}$ s'inverse, le condensateur continuant sa décharge et le potentiel V(amp) augmente après l'instant tc.

Aux instants td et te, le signal ech passe à "1" ce qui correspond à l'application d'un nouvel échantillon $v_i$ en entrée du circuit sommateur 44. Le circuit sommateur 44 passe alors à l'état E1 et donc la charge du condensateur C1. On observe ainsi une augmentation en valeur absolue de la tension $V_{C1}$ à chaque instant td et te. Le front descendant du signal ech commande le passage du sommateur 44 à l'état E2 puisque le signal V(th) est à $V_{thi}$. On observe donc la décharge du condensateur C1 avec une diminution en valeur absolue de la tension $V_{C1}$ entre les instants td et te.

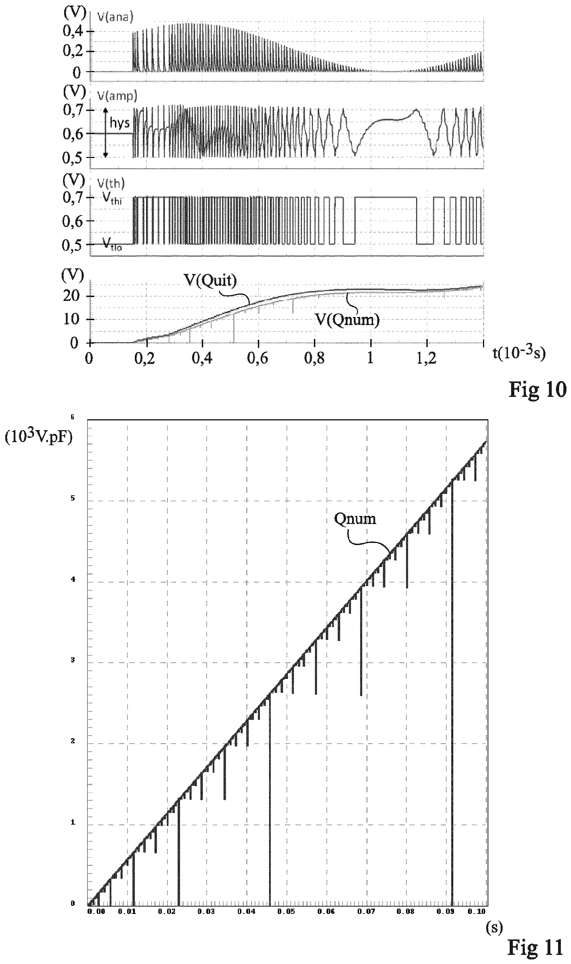

La figure 10 représente des courbes d'évolution en fonction du temps du signal V(ana), du signal V(amp) et du signal V(th) sur une échelle de temps plus grande que la figure 9. En outre, la figure 10 représente une courbe d'évolution V(Qnum) en fonction du temps qui correspond au produit Cint*hys*num et une courbe d'évolution V(Qwit) en fonction du temps, obtenue par simulation, fournie par le circuit intégrateur ayant la structure représentée en figure 1 en l'absence de contraintes physiques. En figure 10, l'amplitude crête à crête du signal V(ana) varie rapidement dans le temps pour montrer le bon fonctionnement du circuit sommateur 44. Toutefois, dans le cas d'un imageur térahertz, le signal V(ana) évolue peu sur une trame.

Chaque pic du signal V(ana) correspond à la transmission au circuit sommateur 44 d'un nouvel échantillon $v_i$ à sommer. La courbe d'évolution du signal V(amp) traduit le repliement par le comparateur à hystérésis du signal de somme à déterminer. Chaque basculement du signal V(th) correspond à une incrémentation du compteur binaire num.

La différence entre les deux courbes V(Qnum) et V(Qwit) provient des imperfections du circuit électronique constituant le circuit de traitement et détermination de somme 40 (notamment le temps de commutation non nul de l'amplificateur G1, du comparateur K1 et des interrupteurs).

Dans cet exemple, on obtient la charge calculée Qwit de 25 V.pF par le circuit de traitement et détermination de somme 40 à l'instant t égal à 1ms, alors que toutes les tensions de ce circuit ont évolué en valeur absolue entre 0 et Vdda (par exemple égal à 1,2 V).

La figure 11 représente une courbe d'évolution de la charge électrique Qnum déterminée à partir du signal num fourni par le circuit de traitement et de détermination de somme 40 de la figure 3 dans le cas où la durée d'intégration Tint est égale à 100 ms, avec des échantillons $v_i$ d'amplitude constante égale à 0,6 V, une fréquence de modulation fmod égale à 100 kHz, une tension d'hystérésis hys égale à 0,6 V et des capacités C1 et Cint égales à 1 pF.

La valeur théorique attendue de la charge électrique est donc égale au produit $Cint.hys.10^4$ soit 6000 V.pF. En figure 11, la courbe Qnum, à l'instant t égal à 100 ms, dépasse la valeur en ordonnée 5700 V.pF, soit 95 % de la valeur théorique. Comme pour l'exemple illustré en figure 10, la différence est due aux imperfections du circuit électronique constituant le circuit de traitement et détermination de somme 40.

Le circuit sommateur 44 selon les modes de réalisation décrits précédemment permet de déterminer la somme

$$\sum_{i=1}^{K} Q_i$$ où $Q_i$ est la charge d'un échantillon et est compris, par exemple, entre 1 fC et 500 fC et K est le nombre d'échantillons à sommer et est un nombre entier supérieur strictement à 1, par exemple compris entre 1 et 10000.

La résolution du circuit sommateur 44 correspond à la charge électrique minimale détectable Qmin qui est égale au produit Cint.hys. La charge électrique minimale Qmin est fixée par la capacité d'intégration Cint et l'hystérésis hys. A titre d'exemple, par exemple Qmin est égal à 200 fC avec Cint égale à 1 pF et hys égal à 200 mV.

De façon générale, la charge minimale Qmin peut être de l'ordre d'une centaine de femtocoulombs et la charge électrique totale $Q_{PE}$ peut être de l'ordre de plusieurs nanocoulombs. La dynamique mesurable est supérieure à 90 dB, de préférence supérieure à 100 dB.

Le circuit sommateur 44 présente les avantages suivants :

- la dynamique du circuit sommateur 44 est élevée ;
- le flux de transmission des échantillons au circuit sommateur 44 peut être sporadique ou régulier ;
- l'amplitude des échantillons peut être variable ;
- la consommation du circuit de traitement et détermination de somme 40 peut être inférieure à 60 $\mu$W. Ceci permet de réaliser le circuit de traitement et détermination de somme 40 de façon intégrée avec le détecteur 30 ; et
- le circuit sommateur 44 fournit directement un signal numérique, ce qui permet d'éviter l'utilisation d'un convertisseur analogique/numérique.

## Revendications

1. Circuit sommateur (44) comprenant :

   un condensateur (C1) comprenant des première et deuxième armatures ;
   un circuit de commutation (sw11, sw12, sw21, sw22, sw23, sw24) adapté à connecter le condensateur (C1) selon une première, une deuxième ou une troisième configuration, la première armature étant connectée à un premier noeud (ana), la deuxième armature étant connectée à un deuxième noeud (ref) et les première et deuxième armatures n'étant pas connectées à un troisième noeud (A) dans la première configuration, la première armature étant connectée au troisième noeud (A), la deuxième armature étant connectée au deuxième noeud et les première et deuxième armatures n'étant pas connectées au premier noeud dans la deuxième configuration et la deuxième armature étant connectée au troisième noeud (A), la première armature étant connectée au deuxième noeud et les première et deuxième armatures n'étant pas connectées au premier noeud dans la troisième configuration, les première et deuxième armatures n'étant pas connectées ensemble dans les première, deuxième et troisième configurations ;
   un intégrateur (68) comprenant un amplificateur opérationnel (G1) dont une entrée est reliée au troisième noeud ;
   un comparateur à hystérésis (70) relié à la sortie de l'intégrateur ; et
   un compteur (72) relié à la sortie du comparateur à hystérésis.

2. Circuit sommateur selon la revendication 1, dans lequel l'intégrateur (68) est adapté à fournir un premier signal (V(amp)) et dans lequel le comparateur à hystérésis (70) est adapté à fournir un deuxième signal (V(comp)) à un premier état ou à un deuxième état selon le résultat de la comparaison du premier signal à un premier seuil ($V_{thi}$) ou à un deuxième seuil ($V_{tlo}$).

3. Circuit sommateur selon la revendication 2, dans lequel le compteur (72) est adapté à incrémenter un signal numérique (num) à chaque front montant et à chaque front descendant du deuxième signal (V(comp)).

4. Circuit sommateur selon l'une quelconque des revendications 1 à 3, dans lequel le circuit de commutation comprend :

   un premier interrupteur (sw11) reliant une première armature du condensateur (C1) au premier noeud (ana) et commandé par un premier signal de commande (ph1) ;
   un deuxième interrupteur (sw12) reliant une deuxième armature du condensateur (C1) au deuxième noeud (ref) et commandé par le premier signal de commande (ph1) ;
   un troisième interrupteur (sw21) reliant la deuxième armature du condensateur (C1) au troisième noeud (A) et commandé par un deuxième signal de commande (ph2a) ;
   un quatrième interrupteur (sw22) reliant la première armature du condensateur (C1) au deuxième noeud (ref) et commandé par le deuxième signal de commande (ph2a) ;
   un cinquième interrupteur (sw23) reliant la première armature du condensateur (C1) au troisième noeud (A) et commandé par un troisième signal de commande (ph2b) ; et
   un sixième interrupteur (sw24) reliant la deuxième armature du condensateur (C1) au deuxième noeud (ref) et commandé par le troisième signal de commande (ph2b).

5. Circuit sommateur selon la revendication 4, comprenant en outre un séquenceur (62) adapté à commander les premier, deuxième, troisième, quatrième, cinquième et sixième interrupteurs (sw11, sw12, sw21, sw22, sw23, sw24) selon l'une des configurations a), b) et c) suivantes :

a) fermeture des premier et deuxième interrupteurs (sw11, sw12) et ouverture des troisième, quatrième, cinquième et sixième interrupteurs (sw21, sw22, sw23, sw24) ;
b) fermeture des troisième et quatrième interrupteurs (sw21, sw22) et ouverture des premier, deuxième, cinquième et sixième interrupteurs (sw11, sw12, sw23, sw24) ; et
c) fermeture des cinquième et sixième interrupteurs (sw23, sw24) et ouverture des premier, deuxième, troisième et quatrième interrupteurs (sw11, sw12, sw21, sw22).

6. Circuit sommateur selon la revendication 5 dans son rattachement à la revendication 2, dans lequel le séquenceur (62) est adapté à commander les premier, deuxième, troisième, quatrième, cinquième et sixième interrupteurs (sw11, sw12, sw21, sw22, sw23, sw24) dans la configuration a) lorsqu'une nouvelle valeur ($v_i$) est appliquée entre les premier et deuxième noeuds (ana, ref).

7. Circuit sommateur selon la revendication 6, dans lequel le séquenceur (62) est adapté à commander les premier, deuxième, troisième, quatrième, cinquième et sixième interrupteurs de la configuration b) à la configuration c) ou de la configuration c) à la configuration b) lorsque le signal (V(amp)) atteint le premier seuil ($V_{thi}$) ou le deuxième seuil ($V_{tlo}$).

8. Circuit de traitement et détermination de somme (40) comprenant un circuit de traitement (42) adapté à recevoir un signal analogique bruité ($u_i$) et adapté à fournir une succession de valeurs constantes ($v_i$) à partir du signal analogique bruité ; et
le circuit sommateur (44) selon l'une quelconque des revendications 1 à 7 adapté à recevoir la succession de valeurs constantes.

9. Circuit de traitement et détermination de somme selon la revendication 8, dans lequel le signal analogique ($u_i$) est un signal oscillant et dans lequel les valeurs constantes ($v_i$) sont représentatives de l'amplitude crête à crête du signal analogique pour des oscillations successives.

10. Système de détection d'un rayonnement électromagnétique comprenant un détecteur du rayonnement électromagnétique (30) et un circuit de traitement et détermination de somme (40) selon l'une quelconque des revendications 8 et 9.

11. Système de détection selon la revendication 10, comprenant une matrice de détecteurs (30) du rayonnement électromagnétique et, pour chaque détecteur, un circuit de traitement et détermination de somme (40) selon l'une quelconque des revendications 8 et 9.

12. Système de détection selon la revendication 10 ou 11, dans lequel la fréquence du rayonnement électromagnétique est comprise entre 100 GHz à 30 THz.

**Patentansprüche**

1. Eine Summierschaltung (44), die Folgendes aufweist:

einen Kondensator (C1) mit ersten und zweiten Platten;
einen Kommutierungs- bzw. Schaltkreis (sw11, sw12, sw21, sw22, sw23, sw24), der in der Lage ist, den Kondensator (C1) gemäß einer ersten, einer zweiten oder einer dritten Konfiguration zu verbinden, wobei in der ersten Konfiguration die erste Platte mit einem ersten Knoten (ana) verbunden ist, die zweite Platte mit einem zweiten Knoten (ref) verbunden ist und die ersten und zweiten Platten nicht mit einem dritten Knoten (A) verbunden sind, wobei in der zweiten Konfiguration die erste Platte mit dem dritten Knoten (A) verbunden ist, die zweite Platte mit dem zweiten Knoten verbunden ist und die ersten und zweiten Platten nicht mit dem ersten Knoten verbunden sind, und wobei in der dritten Konfiguration die zweite Platte mit dem dritten Knoten (A) verbunden ist, die erste Platte mit dem zweiten Knoten verbunden ist und die ersten und zweiten Platte nicht mit dem ersten Knoten verbunden sind, und wobei die ersten und zweiten Platten in der ersten, zweiten und dritten Konfiguration nicht miteinander verbunden sind;

einen Integrator (68), der einen Operationsverstärker (G1) mit einem Eingang aufweist, der mit dritten Knoten gekoppelt ist;
einen Hysteresekomparator (70), der mit dem Ausgang des Integrators gekoppelt ist; und
einen Zähler (72), der mit dem Ausgang des Hysteresekomparators gekoppelt ist.

2. Summierschaltung nach Anspruch 1, wobei der Integrator (68) in der Lage ist, ein erstes Signal (V(amp)) zu liefern, und wobei der Hysteresekomparator (70) in der Lage ist, ein zweites Signal (V(comp)) in einem ersten Zustand oder in einem zweiten Zustand entsprechend dem Ergebnis des Vergleichs des ersten Signals mit einer ersten Schwelle ($V_{thi}$) oder mit einer zweiten Schwelle ($V_{tlo}$) zu liefern.

3. Summierschaltung nach Anspruch 2, wobei der Zähler (72) in der Lage ist, ein digitales Signal (num) für jede steigende Flanke und für jede fallende Flanke des zweiten Signals (V(comp)) zu inkrementieren.

4. Die Summierschaltung nach einem der Ansprüche 1 bis 3, wobei der Kommutierungskreis Folgendes aufweist:

einen ersten Schalter (sw11), der eine erste Platte des Kondensators (C1) mit dem ersten Knoten (ana) koppelt, und der von einem ersten Steuersignal (ph1) gesteuert wird;
einen zweiten Schalter (sw12), der eine zweite Platte des Kondensators (C1) mit dem zweiten Knoten (ref) koppelt, und der durch das erste Steuersignal (ph1) gesteuert wird;
einen dritten Schalter (sw21), der die zweite Platte des Kondensators (C1) mit dem dritten Knoten (A) koppelt, und der durch ein zweites Steuersignal (ph2a) gesteuert wird;
einen vierten Schalter (sw22), der die erste Platte des Kondensators (C1) mit dem zweiten Knoten (ref) koppelt, und der durch das zweite Steuersignal (ph2a) gesteuert wird;
einen fünften Schalter (sw23), der die erste Platte des Kondensators (C1) mit dem dritten Knoten (A) koppelt, und der durch ein drittes Steuersignal (ph2b) gesteuert wird; und
einen sechsten Schalter (sw24), der die zweite Platte des Kondensators (C1) mit dem zweiten Knoten (ref) koppelt, und der durch das dritte Steuersignal (ph2b) gesteuert wird.

5. Summierschaltung nach Anspruch 4, die ferner Folgendes aufweist: einen Sequenzer (62), der in der Lage ist die ersten, zweiten, dritten, vierten, fünften und sechsten Schalter (sw11, sw12, sw21, sw22, sw23, sw24) gemäß einer der folgenden Konfigurationen a), b) und c) zu steuern:

a) erster und zweiter Schalter (sw11, sw12) ein und dritter, vierter, fünfter und sechster Schalter (sw21, sw22, sw23, sw24) aus;
b) dritter und vierter Schalter (sw21, sw22) ein und erster, zweiter, fünfter und sechster Schalter (sw11, sw12, sw23, sw24) aus; und
c) fünfter und sechster Schalter (sw23, sw24) ein und erster, zweiter, dritter und vierter Schalter (sw11, sw12, sw21, sw22) aus.

6. Summierungsschaltung nach Anspruch 5 und Anspruch 2, wobei der Sequenzer (62) in der Lage ist, die ersten, zweiten, dritten, vierten, fünften und sechsten Schalter (sw11, sw12, sw21, sw22, sw23, sw24) in der Konfiguration a) zu steuern, wenn ein neuer Wert ($v_i$) zwischen dem ersten und zweiten Knoten (ana, ref) angelegt wird.

7. Summierungsschaltung nach Anspruch 6, wobei der Sequenzer (62) in der Lage ist, die ersten, zweiten, dritten, vierten, fünften und sechsten Schalter von Konfiguration b) zu Konfiguration c) oder von Konfiguration c) zu Konfiguration b) zu steuern, wenn das Signal (V(amp)) den ersten Schwellenwert ($V_{thi}$) oder den zweiten Schwellenwert ($V_{tlo}$) erreicht.

8. Verarbeitungs- und Summen-Bestimmungsschaltung (40) aufweisend eine Verarbeitungsschaltung (42), die in der Lage ist, ein verrauschtes analoges Signal ($u_i$) zu empfangen, und die in der Lage ist, eine Folge von konstanten Werten ($v_i$) basierend auf dem verrauschten analogen Signal zu liefern; und
die Summierschaltung (44) eines der Ansprüche 1 bis 7, die in der Lage ist die Folge von konstanten Werten zu empfangen.

9. Verarbeitungs- und Summen-Bestimmungsschaltung nach Anspruch 8, wobei das analoge Signal ($u_i$) ein schwingendes Signal ist und wobei die konstanten Werte ($v_i$) für die Spitze-Spitze-Amplitude des analogen Signals für aufeinanderfolgende Schwingungen repräsentativ sind.

10. Detektionssystem für elektromagnetische Strahlung, aufweisend einen Detektor (30) für elektromagnetische Strahlung und die Summen-Verarbeitungs- und Bestimmungsschaltung (40) nach einem der Ansprüche 8 und 9.

11. Detektionssystem nach Anspruch 10, aufweisend eine Anordnung von Detektoren (30) für elektromagnetische Strahlung und für jeden Detektor die Verarbeitungs- und Summenbestimmungsschaltung (40) nach einem der Ansprüche 8 und 9.

12. Detektionssystem nach Anspruch 10 oder 11, wobei die Frequenz der elektromagnetischen Strahlung im Bereich von 100 GHz bis 30 THz liegt.

**Claims**

1. A summing circuit (44) comprising:

   a capacitor (C1) comprising first and second plates;
   a switching circuit (sw11, sw12, sw21, sw22, sw23, sw24) capable of connecting the capacitor (C1) according to a first, a second, or a third configuration, the first plate being connected to a first node (ana), the second plate being connected to a second node (ref) and the first and second plates not being connected to a third node (A), in the first configuration, the first plate being connected to the third node (A), the second plate being connected to the second node and the first and second plates not being connected to the first node in the second configuration and the second plate being connected to the third node (A), the first plate being connected to the second node and the first and second plates not being connected to the first node in the third configuration, the first and second plates not being connected together in the first, second and third configurations;
   an integrator (68) comprising an operational amplifier (G1) having an input coupled to the third node;
   a hysteresis comparator (70) coupled to the output of the integrator; and
   a counter (72) coupled to the output of the hysteresis comparator.

2. The summing circuit of claim 1, wherein the integrator (68) is capable of supplying a first signal (V(amp)) and wherein the hysteresis comparator (70) is capable of supplying a second signal (V(comp)) in a first state or in a second state according to the result of the comparison of the first signal with a first threshold ($V_{thi}$) or with a second threshold ($V_{tlo}$).

3. The summing circuit of claim 2, wherein the counter (72) is capable of incrementing a digital signal (num) for each rising edge and for each falling edge of the second signal (V(comp)).

4. The summing circuit of any of claims 1 to 3, wherein the switching circuit comprises:

   a first switch (sw11) coupling a first plate of the capacitor (C1) to the first node (ana) and controlled by a first control signal (ph1);
   a second switch (sw12) coupling a second plate of the capacitor (C1) to the second node (ref) and controlled by the first control signal (ph1);
   a third switch (sw21) coupling the second plate of the capacitor (C1) to the third node (A) and controlled by a second control signal (ph2a);
   a fourth switch (sw22) coupling the first plate of the capacitor (C1) to the second node (ref) and controlled by the second control signal (ph2a);
   a fifth switch (sw23) coupling the first plate of the capacitor (C1) to the third node (A) and controlled by a third control signal (ph2b); and
   a sixth switch (sw24) coupling the second plate of the capacitor (C1) to the second node (ref) and controlled by the third control signal (ph2b).

5. The summing circuit of claim 4, further comprising a sequencer (62) capable of controlling the first, second, third, fourth, fifth, and sixth switches (sw11, sw12, sw21, sw22, sw23, sw24) according to one of the following configurations a), b), and c):

   a) first and second switches (sw11, sw12) on and third, fourth, fifth, and sixth switches (sw21, sw22, sw23, sw24) off;
   b) third and fourth switches (sw21, sw22) on and first, second, fifth, and sixth switches (sw11, sw12, sw23, sw24) off; and

c) fifth and sixth switches (sw23, sw24) on and first, second, third, and fourth switches (sw11, sw12, sw21, sw22) off.

6. The summing circuit of claim 5 and of claim 2, wherein the sequencer (62) is capable of controlling the first, second, third, fourth, fifth, and sixth switches (sw11, sw12, sw21, sw22, sw23, sw24) to configuration a) when a new value ($v_i$) is applied between the first and second nodes (ana, ref).

7. The summing circuit of claim 6, wherein the sequencer (62) is capable of controlling the first, second, third, fourth, fifth, and sixth switches from configuration b) to configuration c) or from configuration c) to configuration b) when the signal (V(amp)) reaches the first threshold ($V_{thi}$) or the second threshold ($V_{tlo}$).

8. A sum processing and determination circuit (40) comprising a processing circuit (42) capable of receiving a noisy analog signal ($u_i$) and capable of supplying a succession of constant values ($v_i$) based on the noisy analog signal; and the summing circuit (44) of any of claims 1 to 7 capable of receiving the succession of constant values.

9. The processing and sum determination circuit of claim 8, wherein the analog signal ($u_i$) is an oscillating signal and wherein the constant values ($v_i$) are representative of the peak-to-peak amplitude to the analog signal for successive oscillations.

10. A system of detecting an electromagnetic radiation comprising an electromagnetic radiation detector (30) and the processing and sum determination circuit (40) of any of claims 8 and 9.

11. The detection system of claim 10, comprising an array of electromagnetic radiation detectors (30) and, for each detector, the processing and sum determination circuit (40) of any of claims 8 and 9.

12. The detection system of claim 10 or 11, wherein the frequency of the electromagnetic radiation is in the range from 100 GHz to 30 THz.

10

IN pha

swa

phb Ca pha

swb swd

r

phc

swe Cb

phb

swc − G

r + OUT

Fig 1

32

Smo

S0 S1 S2 S3

24 T0 PA AGR F

26 28 ANT 30

22

Fig 2

40

$u_i$ $v_i$ $U_s$

42 $\sum_{i=1}^{K} v_i$

44

Fig 3

Fig 4

Fig 5

Fig 6

Fig 7

Fig 8

Fig 9

Fig 10

Fig 11

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2015040316 A

**Littérature non-brevet citée dans la description**

- **SUZANA DOMINGUES et al.** *A CMOS THz staring imager with in-pixel electronics,* 03 Juillet 2011, ISBN 978-1-4244-9138-4, 81-84